# EUROPEAN PATENT APPLICATION

(11) **EP 0 674 397 A2**
(43) Date of publication of application: **27.09.1995**
(21) Application number: 95301939.5
(22) Date of filing: 23.03.1995
(51) Int. Cl.: H03M 13/00

(54) **Viterbi decoder comprising downsized circuits**

(30) Priority: 24.03.1994 JP 53944/94
(71) Applicant: MATSUSHITA ELECTRIC INDUSTRIAL CO., LTD., Kadoma-shi, Osaka-fu 571 (JP)
(72) Inventor: Ohta, Kazuhiro, Osaka-shi, Osaka 532 (JP); Kimura, Tomohiro, Kawachinagano-shi, Osaka 586 (JP); Nakaishi, Yasuo, Ikoma-shi, Nara 630-01 (JP)
(74) Representative: Cummings, Sean Patrick

(57) **Abstract**

A viterbi decoder for decoding a convolutional coded sequence transmitted from an encoder via a channel, wherein a plurality of paths representing a possible pre-coding data sequence and a path metric representing a likelihood of each path are calculated through a metric operation, and one of the plurality of paths is decided to be a decoding result through maximum likelihood decision based on the path metric, the viterbi decoder comprising: a metric converting unit for converting a value of the path metric to output a state metric, the value being converted into k when the value is more than k, where k is a predetermined integer within a range for the path metric, and left intact when the value is equal to or less than k; and a maximum likelihood deciding unit for deciding a minimum state metric using a path corresponding to the minimum state metric. The path metric is represented by m bits for each path, where m is an integer; and k is 2^{m-n}-1, where n is an integer in a range from one to m-1 inclusive; the metric converting unit includes a plurality of metric converting circuits provided for the plurality of paths, respectively, each comprising m-n (n+1)-input OR gates that calculate OR's of upper n bits of a corresponding path metric and each lower bit to output (m-n)-bit state metric, whereby the maximum likelihood deciding unit decides the minimum state metric using the same.

## Description

### BACKGROUND OF THE INVENTION

### (1) Field of the Invention

The present invention relates to a viterbi decoder which maximum likelihood decodes a convolutional coded signal sequence.

### (2) Description of the Related Art

Convolutional coding is a known art for successively coding an information sequence per symbol. Individual data symbols in the information sequence are coded depending on the state at the time of coding, that is to say, the preceding data symbol/symbols of a data symbol being coded. Since the error correction performance for errors occurring while the coded signal sequence is transmitted via a channel is high with the convolutional coding, it is expected to be applied to various communication systems.

The convolutional coded signal sequence is decoded by, for example, the maximum likelihood decoding. In the maximum likelihood decoding, the input data, or namely a noise-affected convolutional coded signal sequence traveling through the noisy channel, are decoded into a plurality of likely information sequences in compliance with the coding rule, and the one that is possibly transmitted is decided in favor of the maximum. A viterbi decoder is known as a typical maximum likelihood decoder, and more detailed information is given in "Convolutional Codes and Their Performance in Communication System", Andrew J. Viterbi, IEEE Transactions of Communications Technology, Vol. Com-19, No. 5, October 1971, pp751-772. Also, the inventions related to the viterbi decoder are disclosed in Japanese Laid-open Patent Application Nos. 60-111533, 61-66412, and 61-161027.

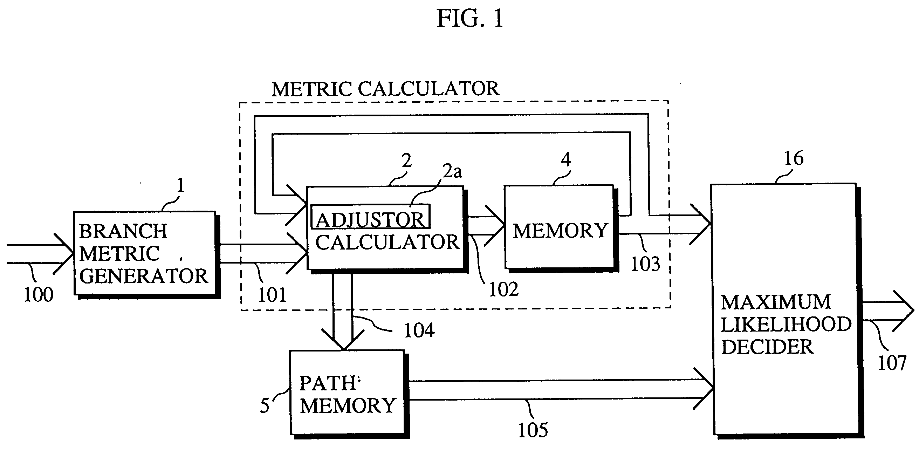

Figure 1 is a block diagram depicting the structure of a conventional viterbi decoder, which comprises a branch metric generator 1, a calculator 2, a memory 4, a path memory 5, and a maximum likelihood decider 16.

In the drawing, numeral 100 denotes a received signal, which is in effect a convolutional coded sequence transmitted from an encoder provided at a sender's end via a transmission channel. The convolutional coded sequence is transmitted per symbol at a time. Assume that, in the coded sequence, one symbol is represented by two bits, the encoding rate R is 1/2 (R=½), and the constraint length K is three (K=3). Thus, in the pre-coding information sequence, one symbol is represented by one bit and the encoder holds four states.

Numeral 101 denotes a branch metric representing the likelihood of each branch. The branch referred herein is a line connecting the state at time (t-1) and the state at time t in the trellis diagram to indicate to which state a state has changed (in the trellis diagram, the horizontal axis represents the time when a symbol is received while the vertical axis representing the states). Assume that the branch metric is represented by two bits herein.

Numeral 102 denotes a path metric representing the likelihood of a path for each state. The path referred herein means the history of the transition of each state, that is to say, whether each state is changed from a symbol "1" or "0". In the trellis diagram, the path is a sequence of binary digits of "0's" and "1's" represented by a series of branches. Assume that the path metric for each state is represented by three bits herein.

Numeral 103 denotes a path metric preceding to each path metric 102 by one time.

Numeral 104 denotes a path signal indicating the transition of each state, that is to say, whether each state has changed by a symbol "0" or "1". Assume that the path signal for each state is represented by one bit herein.

Numeral 105 denotes a candidate for the result of decoding for each state.

Numeral 107 denotes a decoding result selected from the candidates in accordance with the maximum likelihood decision.

The branch metric generator 1, upon input of the received signal 100, calculates the branch metric 101 for each branch.

A metric calculator comprised of the calculator 2 and memory 4, which is indicated by a dotted rectangle in the drawing, receives the branch metric 101 and outputs the path metric 103 and path signal 104.

The calculator 2, upon input of the branch metric 101 and path metric 103, performs a metric operation for each state to calculate the path metric 102 and a new path signal 104. An adjuster 2a provided in the calculator 2 adjusts the value of the path metric for each state to be in a predetermined range while maintaining a correlation in terms of largeness. Because the minimum value of the path metric is always zero when there is no transmission error in the receiving signal 100, and, once the transmission error occurs, it becomes greater as the time elapses. The value of the path metric is adjusted to avoid an overflow, and to yield a small value for the minimum value, for example, zero, one or two for a 3-bit path metric.

The memory 4 holds the path metric 102 from the calculator 2 and outputs the same as the path metric 103 at the following time.

The path memory 5 receives the path signal 104, and holds a path representing the history of the symbol value for each state specified by the path signal for the latest T times, where T is an integer equal to or more than two, and outputs the oldest one bit for each state among the paths as the candidate 105.

The maximum likelihood decider 16 receives the path metric 103 and candidate 105 for each state and checks the smallest path metric 103 to output the candidate 105 for the state corresponding to the smallest path metric as the decoding result 107.

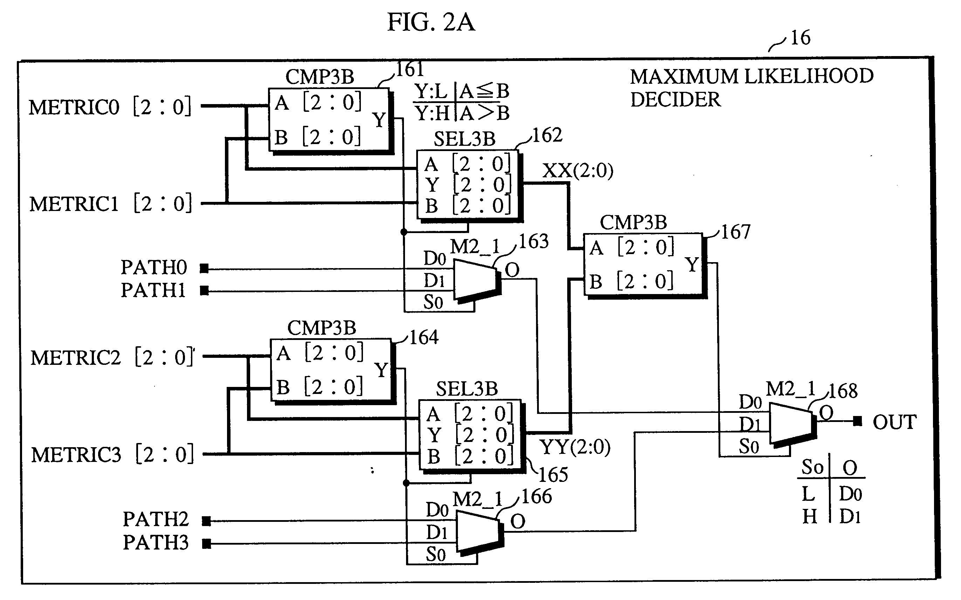

Figure 2A is a block diagram depicting the structure of a circuit forming the maximum likelihood decider 16. The maximum likelihood decider 16 comprises a 3-bit comparator 161, a selector 162, a selector 163, a 3-bit comparator 164, a selector 165, a selector 166, a 3-bit comparator 167, and a selector 168. In the drawing, METRIC0[2:0], METRIC1[2:0], METRIC2[2:0], and METRIC3[2:0] represent the path metrics from the memory 4 in the states 0, 1, 2, and 3, respectively. Also, PATH0, PATH1, PATH2, and PATH3 represent the oldest 1-bit candidates for the paths from the path memory 5 in the states 0, 1, 2, and 3, respectively.

The comparator 161 and selector 162 compare METRIC0[2:0] with METRIC1[2:0] to select and output whichever smaller, and the resulting output is referred to as XX[2:0].

The selector 163 selects either PATH0 or PATH1 depending on the path metric selected by the selector 162.

The comparator 164 and selector 165 compare METRIC2[2:0] with METRIC3[2:0] to select and output whichever smaller, and the resulting output is referred to as YY[2:0].

The selector 166 selects either PATH2 or PATH3 depending on the path metric selected by the selector 165.

The comparator 167 compares XX[2:0] with YY[2:0], and outputs Y=L when XX≦YY and Y=H when XX>YY.

The selector 168 receives the outputs from the selectors 163 and 166, and outputs one of them as the decoding result by selecting the output from the selector 163 when the comparator outputs Y=L and the output from the selector 166 when Y=H.

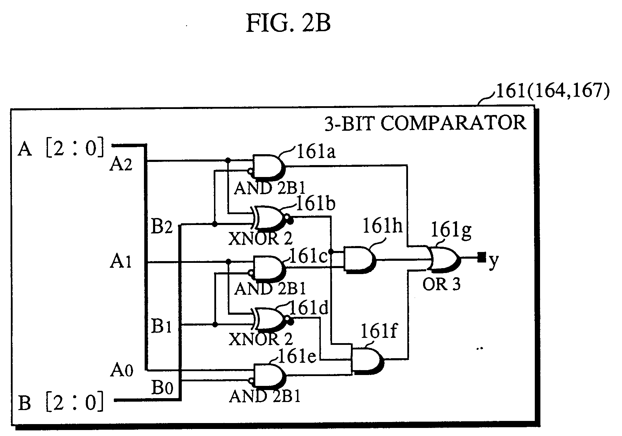

Figure 2B shows a circuit forming the comparator 161. As is shown in the drawing, the comparator 161 comprises gates 161a-161h. The comparator receives two 3-bit data, A[2:0] and B[2:0], and compares the same to output the comparison result, Y=L when A≦B and Y=H when A>B. The comparators 164 and 167 are of the same structure.

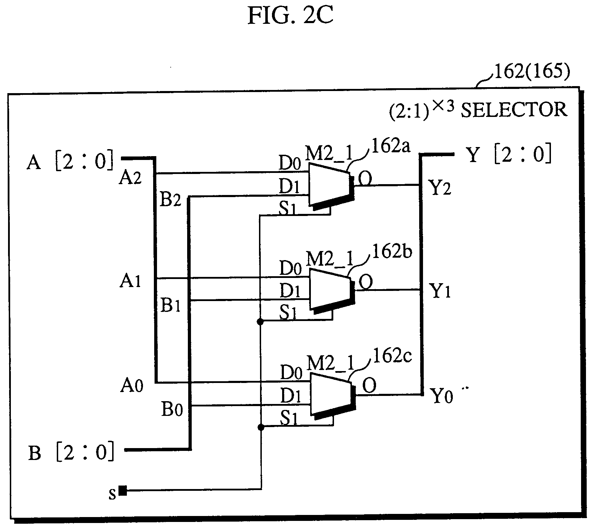

Figure 2C shows a circuit forming the selector 162. As is shown in the drawing, the selector 162 comprises three 2-input·1-output 1-bit selectors 162a, 162b, and 162c, and each selects one of the inputs for a selection signal s. The input D0 (A side) is selected when s=L, and D1 (B side) when s=H.

The operation of the above-structured viterbi decoder will be explained in the following.

The received signal 100 is inputted into the branch metric generator 1 per symbol (two bits) at a time, which calculates the branch metric 101 for each branch and outputs the same to the calculator 2.

The calculator 2 performs the metric operation for each state using the branch metric 101, and the path metric 103 from the memory 4 to calculate the path metric 102 and the new path signal 104 for each state.

The memory 4 outputs the path metric 103 and new path signal 104 and holds the path metric 102 from the calculator 2 as a new path metric.

The path memory 5 receives one path signal 104 at a time, and stores the value thereof for each state as the candidate while outputting the oldest one bit for each state in the paths as the candidate 105.

The maximum likelihood decider 16 calculates the smallest path metric in all the states, and outputs the candidate for the states corresponding to the smallest path metric as the decoding result.

As has been explained, the conventional viterbi decoder maximum likelihood decodes the convolutional coded sequence by performing a series of branch metric generation, metric operation, update of the path memory, and maximum likelihood decision at a time.

The conventional viterbi decoder, however, demands a large-scale circuit. To be more specific, the maximum likelihood decider 16 uses the circuits shown in Figures 2A, 2B, and 2C to select the smallest path metric by comparing all of the path metrics, and it is general to use a path metric of a greater number of bits to upgrade the error correction performance. Although a 3-bit metric is used for each state as an example herein, the grater the number of the bits, the larger the circuits in the maximum likelihood decider 16.

### SUMMARY OF THE INVENTION

Accordingly, the present invention has an object to provide a viterbi decoder comprising downsized circuits.

The above object can be fulfilled by a viterbi decoder for decoding a convolutional coded sequence transmitted from an encoder via a channel, wherein a plurality of paths representing a possible pre-coding data sequence and a path metric representing a likelihood of each path are calculated through a metric operation, and one of the plurality of paths is decided to be a decoding result through maximum likelihood decision based on the path metric, the viterbi decoder comprising: a metric converting unit for, upon input of the path metric, converting a value thereof to output a conversion result as a state metric, the value being converted into k when the value is more than k, where k is a predetermined integer within a range for the path metric, and left intact when the value is equal to or less than k; and
a maximum likelihood deciding unit for deciding a minimum state metric to output the decoding result using a path corresponding to the minimum state metric.

The path metric may be represented by m bits for each path, where m is an integer, and k may be 2^{m-n}-1, where n is an integer in a range from one to m-1 inclusive. The metric converting unit may include a plurality of metric converting circuits, each being provided for the plurality of paths, respectively, each comprising m-n (n+1)-input OR gates that calculate OR's of upper n bits of a corresponding path metric and each lower bit to output (m-n)-bit state metric, whereby the maximum likelihood deciding unit decides the minimum state metric using the (m-n)-bit state metric.

The path metric may be represented by three bits for each state; and the metric converting unit may include a plurality of metric converting circuits, each being provided for the plurality of paths, respectively, each comprising two 2-input OR gates that calculate OR's of an MSB of a corresponding path metric and each bit other than the MSB to output a 2-bit state metric, whereby the maximum likelihood deciding unit judges the minimum state metric based on the 2-bit state metric.

According to the above structure, the path metric can be represented by a smaller number of bits as the result of conversion, which can simplify the structure of the circuit forming the maximum likelihood decider while reducing the size thereof.

The above object can also be fulfilled by a viterbi decoder for decoding a sequence convolutional coded by unit of an encoder holding a finite-state, comprising: a branch metric generating unit for generating a branch metric representing a likelihood of each branch based on an input code symbol in the convolutional coded sequence, one code symbol being inputted at a time, the branch representing a possible state transition in the encoder and a data symbol causing the state transition; a metric operation unit for outputting a path metric representing a likelihood of a path composed of a series of branches, and a path signal representing a value for a possibly transmitted pre-coding data symbol as a result of a metric operation using the branch metric for each state; a path memory for holding the path signal for each state for T times as a history thereof, where T is an integer equal to or more than two, and for outputting oldest path signal for each state; a metric converting unit for, upon input of the path metric for each state, converting a value thereof to output a conversion result as a state metric, the value being converted into k when the value is more than k, where k is a predetermined integer in a range for the path metric, and left intact when the value is equal to or less than k; and a maximum likelihood deciding unit for deciding a minimum state metric to output a decoding result using a path corresponding to the minimum state metric.

The metric operation unit may include: a metric operation circuit for performing the metric operation for each state using a preceding path metric and the input branch metric to calculate the path metric and the path signal, the path metric being an integer equal to or more than zero and less than 2^{m}, where m is an integer equal to or more than one; a subtracting circuit for subtracting a minimum value among the path metrics for all the states from a value of the path metric for each state; and a memory for holding the path metric for each state received from the subtracting circuit at a time to output the same with a 1-time delay, whereby the metric converting circuit converts the 1-time delayed path metric from the memory.

According to the above structure, the minimum value of the pre-conversion path metric becomes always zero, which can further simplify the structure of the circuit forming the maximum likelihood decider while further reducing the size thereof.

### BRIEF DESCRIPTION OF THE DRAWINGS

These and other objects, advantages and features of the invention will become apparent from the following description thereof taken in conjunction with the accompanying drawings which illustrate a specific embodiment of the invention. In the drawings:
Figure 1 is a block diagram depicting the structure of a conventional viterbi decoder;
Figure 2A is a block diagram depicting the structure of a circuit forming a conventional maximum likelihood decider;
Figure 2B is a view showing a circuit of a comparator in the conventional maximum likelihood decider;
Figure 2C is a view showing a circuit of a selector in the conventional maximum likelihood decider;
Figure 3 is a block diagram depicting the structure of a viterbi decoder in accordance with an embodiment of the present invention;
Figure 4A is a block diagram depicting the structure of a convertor of the present invention;
Figure 4B is a view showing the structure of a metric converting circuit of the present invention;
Figure 5A is a block diagram depicting the structure of a circuit forming a maximum likelihood decider of the present invention;
Figure 5B is a view showing a circuit of a comparator in the maximum likelihood decider of the present invention; and
Figure 5C is a view showing a circuit of a selector in the maximum likelihood decider of the present invention.

### DESCRIPTION OF THE PREFERRED EMBODIMENT

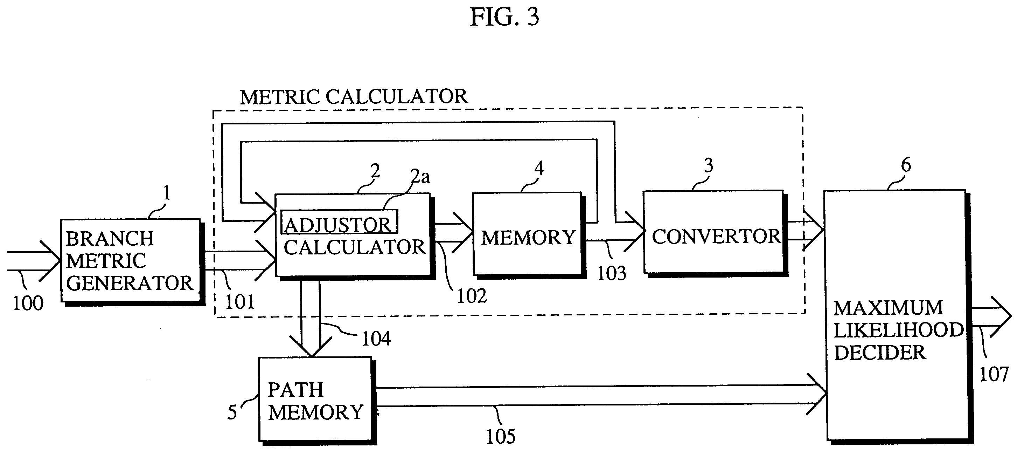

Figure 3 is a block diagram depicting the structure of a viterbi decoder in accordance with an embodiment of the present invention. The viterbi decoder comprises a branch metric generator 1, a calculator 2, a convertor 3, a memory 4, a path memory 5, and a maximum likelihood decider 6. The branch metric generator 1, calculator 2, memory 4 and path memory 5 are of the same structure as their respective counterparts of the conventional viterbi decoder, and the explanation thereof is omitted.

Likewise, numerals 100-104, 105, and 107 are identical with their respective counterparts of the conventional viterbi decoder, and the explanation thereof is not repeated.

Numeral 106 denotes a path metric, which may be referred as a state metric, converted from each path metric 103 by means of the convertor 3. Assume that, in the coded sequence, one symbol is represented by two bits, the encoding rate R is 1/2 (R=½), and the constraint length K is three (K=3). Thus, in the pre-coding information sequence, one symbol is represented by one bit and the encoder holds four states. Also assume that the branch metric 101 is represented by two bits, each of the path metrics 102 and 103 is represented by three bits, and the path signal for each state is represented by one bit.

The calculator 2 is identical with its counterpart in the conventional viterbi decoder. However, the adjuster 2a that adjusts the value of the path metric is a subtracting circuit herein. Thus, the adjuster 2a subtracts the minimum value among the values of the path metrics for all the states from the value of the path metric in each state, and outputs the subtraction result as the path metric 102, invariably yielding zero for the minimum value.

The convertor 3 receives the path metric 103 from the memory 4, and leaves the value thereof intact when it is equal to or less than k; otherwise, the convertor 3 converts the value into k and outputs the same to the maximum likelihood decider 6. To be more specific, since the path metric 103 is represented by three bits for each state, the value in the path metric 103 is an integer in a range from zero to seven. Herein, assume that the convertor 3 leaves the value intact when it is equal to or less than three, and converts the value into three otherwise, and outputs the value, either left intact or converted, to the maximum likelihood decider 6 as the path metric 106. Thus, the path metric 106 can be represented by two bits for each state.

The maximum likelihood decider 6, upon input of the path metric 106 and candidate 105 for each state, calculates the smallest path metric 106 to output the candidate for the state corresponding to the smallest path metric 106 as the decoding result 107.

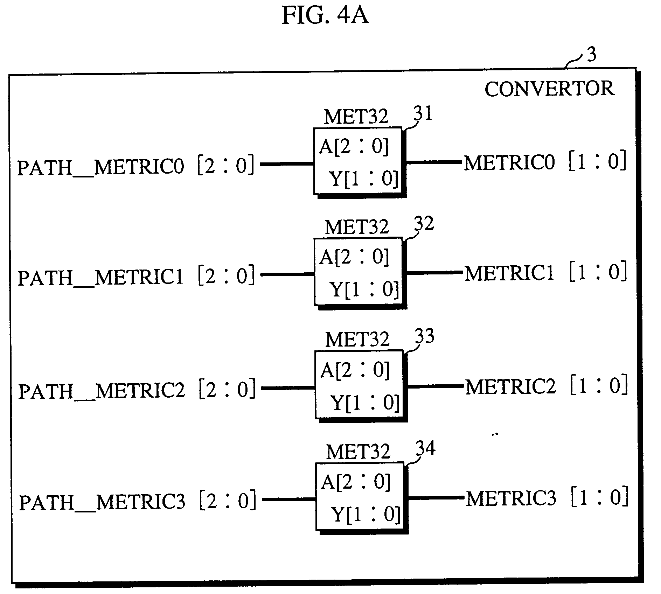

Figure 4A is a view showing the structure of the circuit forming the convertor 3. As is shown in the drawing, the convertor 3 includes four metric converting circuits 31 through 34 for the states, 0, 1, 2, and 3, respectively. In the drawing, PATH_METRIC0[2:0], PATH_METRIC1[2:0], PATH_METRIC2[2:0], and PATH_METRIC3[2:0] denote the 3-bit path metrics from the memory 4 for the states 0, 1, 2, and 3, respectively. METRIC0[2:0], METRIC1[2:0], METRIC2[2:0], and METRIC3[2:0] denote the post-conversion 2-bit path metric for the states 0, 1, 2, and 3, respectively.

The metric converting circuit 31 receives PATH_METRIC0[2:0], which varies in a range from zero to seven, and when PATH_METRIC0[2:0] is more than three, it converts the same into three to output 2-bit METRIC0[1:0].

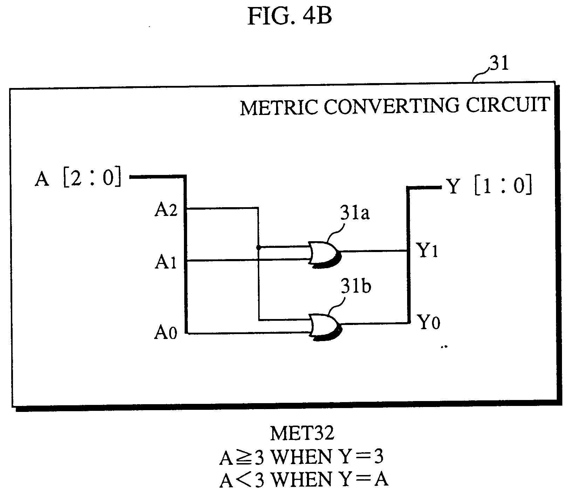

Figure 4B shows a circuit forming the metric converting circuit 31 more in detail. As is shown in the drawing, the metric converting circuit 31 comprises OR gates 31a and 31b. The metric converting circuit 31 converts a value greater than three into three easily using the boolean logic, Y1=A2+A1, Y2=A2+A0, reducing the number of bits to two from three.

The metric converting circuits 32 through 34 are of the same structure as the metric converting circuits 31.

As has been explained, the path metric is converted into the one in a shorter bit length by means of the convertor 3. Thus, the levels of the value of the path metric is reduced to four from eight. However, it should be noted that converting the value of the path metric does not affect the maximum likelihood decision. Because although eight levels are conventionally used to find the path metric with the minimum value, it is well known from the experiences that the minimum value of the path metric becomes zero, one, two, or three in most of the cases due to the adjuster 2a. Since the subtraction circuit serves as the adjuster 2a herein, the minimum value becomes always zero.

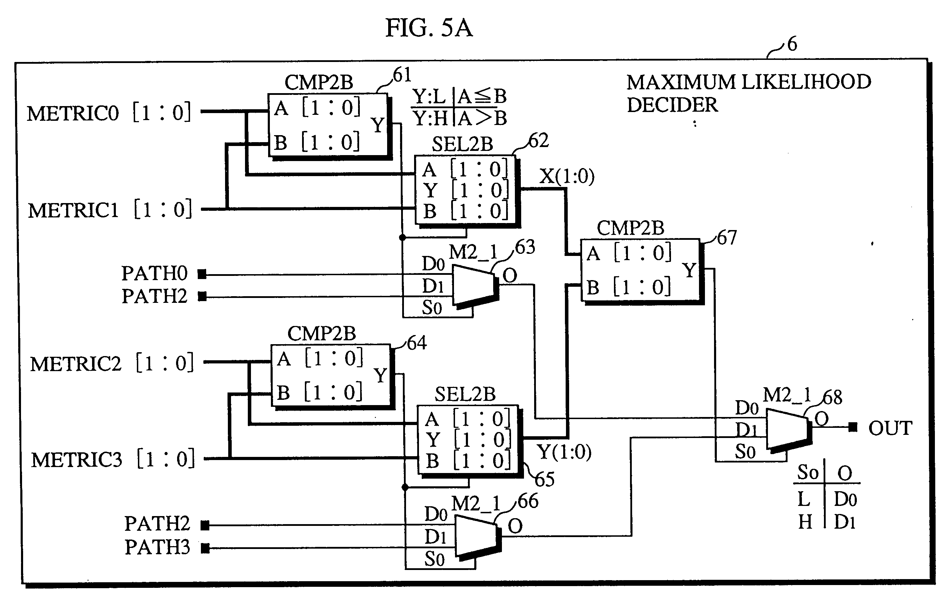

Figure 5A is a block diagram depicting the structure of a circuit forming the maximum likelihood decider 6. The maximum likelihood decider 6 comprises a 2-bit comparator 61, a selector 62, a selector 63, a 2-bit comparator 64, a selector 65, a selector 66 a 2-bit comparator 67, and a selector 68. In the drawing, METRIC0[1:0], METRIC1[1:0], METRIC2[1:0], METRIC3[1:0] represent the post-conversion path metrics from the convertor 3 for the states 0, 1, 2 and 3, respectively. Also, PATH0, PATH1, PATH2, and PATH3 represent the oldest 1-bit candidates from the path memory 5 for the states 0, 1, 2, and 3, respectively.

The comparator 61 and selector 62 compares METRIC0[1:0] with METRIC1[1:0] to select and output whichever smaller, and the resulting output is referred to as X[1:0].

The selector 63 selects either PATH0 or PATH1 depending on the path metric selected by the selector 62.

The comparator 64 and selector 65 compares METRIC2[1:0] with METRIC3[1:0] to select and output whichever smaller, and the resulting output is referred to as Y[1:0].

The selector 66 selects and outputs either PATH2 or PATH3 depending on the path metric selected by the selector 65.

The comparator 67 compares X[1:0] with Y[1:0], and outputs Y=L when X[1:0]≦Y[1:0] and Y=H when X[1:0]>Y[1:0].

The selector 68 receives the outputs from the selectors 63 and 66, and outputs one of them as the decoding result by selecting the output form the comparator 63 when Y=L, and the output from the comparator 67 when Y=H.

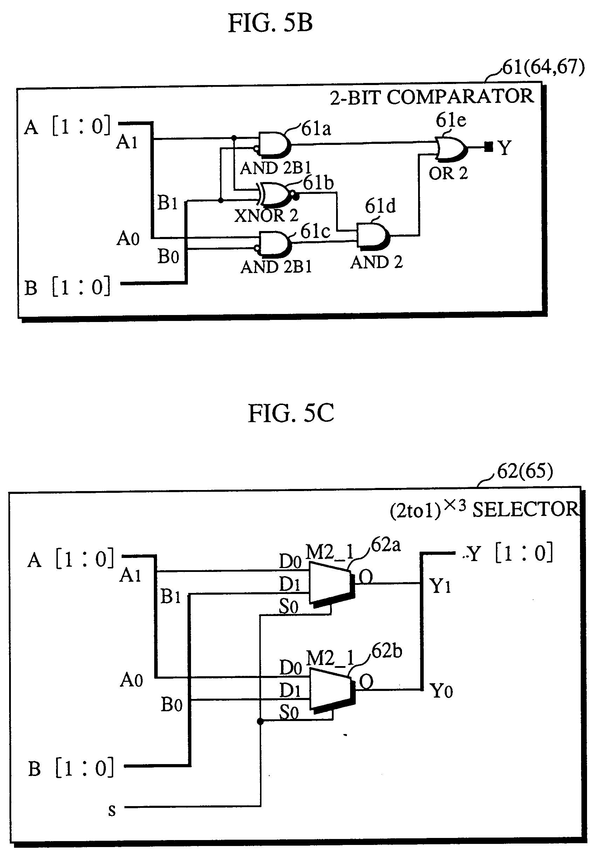

Figure 5B is a view showing a circuit forming the comparator 61. As is shown in the drawing, the comparator 61 comprises gates 61a through 61d. The circuit receives two 2-bit data, A[1:0] and B1[1:0], and compares the same to output the comparison result Y=L when A≦B and Y=H when A>B. The comparators 64 and 67 operate in the same manner.

Figure 5C is a view showing a circuit forming the selector 62. As is shown in the drawing, the selector 62 comprises two 2-input·1-output 1-bit selectors 62a and 62b, and each selects one of the inputs (D0 and D1) depending on a selection signal s. D0 (A side) is selected when s=L and D1 (B side) when s=H.

The operation of the above viterbi decoder will be explained in the following. The branch metric generator 1, calculator 2, memory unit 4, and path memory 5 operate in the same manner as their respective counterparts of the conventional viterbi decoder, and the explanation is not repeated.

The convertor 3 receives the 3-bit path metrics from the memory 4 (PATH_METRIC0[2:0], PATH_METRIC1[2:0], PATH_METRIC2[2:0], and PATH_METRIC3[2:0] in Figure 4A) for each of the states 0, 1, 2 and 3. Although the value in each path metric varies in a range from zero to seven, the convertor 3 converts the value into three if it is more than three, and leaves the same intact when it is equal to or less than three, converting the 3-bit path metrics into the 2-bit path metrics (METRIC0[2:0], METRIC1[2:0], METRIC2[2:0], and METRIC3[2:0] in Figure 4A).

The path metric for each state thus converted is entered into the maximum likelihood decider 6, which calculates the smallest path metric and outputs the candidate for the state corresponding to the smallest path metric as the decoding result.

As has been explained, the viterbi decoder of the present invention converts the path metric into the one in a shorter bit length. Thus, the maximum likelihood decider 6 can be comprised of a downsized circuit compared with the conventional maximum likelihood decider 16. Although eight OR gates in the convertor 3 are additionally included, such an increase is offset by downsizing of the maximum likelihood circuit 6, enabling a viterbi decoder comprising downsized circuits.

Note that the maximum likelihood circuit 6 is realized in the form of hardware herein, but the amount of processing can be reduced as well when it is realized in the form of a software program once the convertor 3 is provided.

Note that the minimum of the post-conversion path metric for each state is always zero because the adjuster 2a subtracts the minimum from the value of each path metric. Thus, the convertor 3 may convert the value into one when it is more than one, and leaves the same intact when it is one or zero. By so doing, each path metric can be represented by one bit, further downsizing the maximum likelihood decider 6.

When each pre-conversion path metric is represented by m bits, each metric converting circuit in the convertor 3 may comprise m-n (n+1)-input OR gates that calculate the OR's of the upper n (n is greater than one and less than m-1 inclusive) bits of the corresponding path metric and each lower bit. Thus, if the pre-conversion value is more than 2^{m-n}-1, it is converted into 2^{m-n}-1, and if it is equal to or less than 2^{m-n}-1 it is left intact. As a result, the post-conversion path metric can be represented by m-n bits(m = 3, n = 1 herein). Accordingly, each post-conversion path metric can be represented by any number of bits. The greater n becomes, the simpler the maximum likelihood decider 6 becomes in the stage subsequent to the convertor 3, further downsizing the circuit.

Although the present invention has been fully described by way of example with reference to the accompanying drawings, it is to be noted that various changes and modification will be apparent to those skilled in the art. Therefore, unless otherwise such changes and modifications depart from the scope of the present invention, they should be construed as being included therein.

## Claims

1. A viterbi decoder for decoding a convolutional coded sequence transmitted from an encoder via a channel, wherein a plurality of paths representing a possible pre-coding data sequence and a path metric representing a likelihood of each path are calculated through a metric operation, and one of said plurality of paths is decided to be a decoding result through maximum likelihood decision based on said path metric, said viterbi decoder comprising:
metric converting means for, upon input of the path metric, converting a value thereof to output a conversion result as a state metric, said value being converted into k when said value is more than k, where k is a predetermined integer within a range for the path metric, and left intact when said value is equal to or less than k; and
maximum likelihood deciding means for deciding a minimum state metric to output the decoding result using a path corresponding to the minimum state metric.

2. The viterbi decoder of Claim 1, wherein
the path metric is represented by m bits for each path, where m is an integer;
said k is 2^{m-n}-1, where n is an integer in a range from one to m-1 inclusive; and
said metric converting means includes a plurality of metric converting circuits, each being provided for said plurality of paths, respectively, each comprising m-n (n+1)-input OR gates that calculate OR's of upper n bits of a corresponding path metric and each lower bit to output (m-n)-bit state metric, whereby said maximum likelihood deciding means decides the minimum state metric using the (m-n)-bit state metric.

3. The viterbi decoder of Claim 1, wherein
the path metric is represented by three bits for each state; and
said metric converting means includes a plurality of metric converting circuits, each being provided for said plurality of paths, respectively, each comprising two 2-input OR gates that calculate OR's of an MSB of a corresponding path metric and each bit other than the MSB to output a 2-bit state metric, whereby said maximum likelihood deciding means judges the minimum state metric based on the 2-bit state metric.

4. A viterbi decoder for decoding a sequence convolutional coded by means of an encoder holding a finite-state, comprising:
branch metric generating means for generating a branch metric representing a likelihood of each branch based on an input code symbol in said convolutional coded sequence, one code symbol being inputted at a time, said branch representing a possible state transition in said encoder and a data symbol causing said state transition;
metric operation means for outputting a path metric representing a likelihood of a path composed of a series of branches, and a path signal representing a value for a possibly transmitted pre-coding data symbol as a result of a metric operation using the branch metric for each state;
a path memory for holding the path signal for each state for T times as a history thereof, where T is an integer equal to or more than two, and for outputting oldest path signal for each state;
metric converting means for, upon input of the path metric for each state, converting a value thereof to output a conversion result as a state metric, said value being converted into k when said value is more than k, where k is a predetermined integer in a range for the path metric, and left intact when said value is equal to or less than k; and
maximum likelihood deciding means for deciding a minimum state metric to output a decoding result using a path corresponding to the minimum state metric.

5. The viterbi decoder of Claim 4, wherein
said metric operation means includes:
a metric operation circuit for performing the metric operation for each state using a preceding path metric and the input branch metric to calculate the path metric and the path signal, the path metric being an integer equal to or more than zero and less than 2^{m}, where m is an integer equal to or more than one;
a subtracting circuit for subtracting a minimum value among the path metrics for all the states from a value of the path metric for each state; and
a memory for holding the path metric for each state received from said subtracting circuit at a time to output the same with a 1-time delay, whereby said metric converting circuit converts the 1-time delayed path metric from said memory.

6. The viterbi decoder of Claim 5, wherein
the path metric is represented by m bits for each path, where m is an integer; and
said k is 2^{m-n}-1, where n is an integer in a range from one to m-1 inclusive;
said metric converting means includes a plurality of metric converting circuits, each being provided for said plurality of paths, respectively, each comprising m-n (n+1)-input OR gates that calculate OR's of upper n bits of a corresponding path metric and each lower bit to output (m-n)-bit state metric, whereby said maximum likelihood deciding means decides the minimum state metric using the (m-n)-bit state metric.

7. The viterbi decoder of Claim 5, wherein
the path metric is represented by three bits for each state; and
said metric converting means includes a plurality of metric converting circuits, each being provided for said plurality of paths, respectively, each comprising two 2-input OR gates that calculate OR's of an MSB of a corresponding path metric and each bit other than the MSB to output a 2-bit state metric, whereby said maximum likelihood deciding means judges the minimum state metric based on the 2-bit state metric.
